# EUROPÄISCHE PATENTSCHRIFT

(11) **EP 2 914 761 B1**
(45) Veröffentlichungstag und Bekanntmachung des Hinweises auf die Patenterteilung: **05.10.2016**
(21) Anmeldenummer: 13785856.9
(22) Anmeldetag: 31.10.2013
(51) Int. Cl.: C23C 14/06, F16J 9/26

(54) **GLEITELEMENT, INSBESONDERE KOLBENRING, MIT EINER BESCHICHTUNG**
SLIDING ELEMENT, IN PARTICULAR A PISTON RING, HAVING A COATING
ÉLÉMENT DE COULISSEMENT, EN PARTICULIER SEGMENT DE PISTON, DOTÉ D'UN REVÊTEMENT

(30) Priorität: 31.10.2012 DE 102012219930
(43) Veröffentlichungstag der Anmeldung: 09.09.2015
(73) Patentinhaber: Federal-Mogul Burscheid GmbH, 51399 Burscheid (DE)
(72) Erfinder: KENNEDY, Marcus, 40479 Düsseldorf (DE); LAMMERS, Ralf, 42929 Wermelskirchen (DE); IVANOV, Yuriy, 51399 Burscheid (DE); ZINNABOLD, Michael, 51399 Burscheid (DE)
(74) Vertreter: Hoffmann Eitle
(86) Internationale Anmeldenummer: PCT/EP2013/072781
(87) Internationale Veröffentlichungsnummer: WO 2014/068040

(56) Entgegenhaltungen:
- DE-A1-102008 022 039
- DE-B3-102008 016 864
- JP-A- 2000 128 516
- US-A1- 2008 220 257

## Beschreibung

### Technisches Gebiet der Erfindung

Die Erfindung betrifft ein Gleitelement, insbesondere einen Kolbenring, mit mindestens einer Lauffläche, die eine Beschichtung aufweist, welche von innen nach außen eine metallhaltige Haftschicht und eine DLC-Schicht, bestehend aus einer Deck- und einer Hauptschicht, aufweist.

### Stand der Technik

Zunehmend strengere gesetzliche Rahmenbedingungen und gesteigerte Kundenwünsche nach weniger Kraftstoffverbrauch von Verbrennungskraftmaschinen erfordern eine nachhaltige Reduzierung von mechanischen Reibungsverlusten. Diese geht aber auch einher mit deutlich gestiegenen Bauteilanforderungen durch Einführung von Leistungsoptimierungen wie Direkteinspritzung und Turboaufladung, welche ihrerseits besonders verschleißresistente Bauelemente erfordern.

Zur Absicherung der Lebensdauer von hochbelasteten Kolbenringen werden zunehmend Hartmetallbeschichtungen eingesetzt, wie in DE 44 19 713 beschrieben. Dabei werden Metallnitride wie z.B. CrN und TiN als Single- oder Multilayer, meist mittels physikalischer Gasphasenabscheidung, ausgeführt.

Um die Reibung im System Kolbenring/Zylinderlaufbahn zu reduzieren werden amorphe DLC (diamond-like carbon) Beschichtungen eingesetzt (VDI Norm 2840). Diese weisen aber eine noch zu geringe Lebensdauer auf. Und wegen der Ausbildung von Eigenspannungen, welche die Haftfähigkeit und somit die Lebensdauer verringern, sind die aufzubringenden Schichtdicken auf ca. 5 *µ*m begrenzt, wie in DE 10 2005 063 123 B beschrieben.

Die DE 40 40 456 C1 und die DE 198 50 218 C1 beschreiben die Erzeugung von amorphen, wasserstofffreien diamantähnlichen Kohlenstoffschichtsystemen mittels herkömmlicher Sputtervorgänge oder sogenannter Vakuum Arc-Prozesse. Von der hohen Härte der Schichten verspricht man sich verbesserte Verschleißwerte. Die Härte wird dabei maßgeblich durch den Bindungscharakter, d.h. das Verhältnis aus sp2 zu sp3 Kohlenstoffbindungen bestimmt. Je höher der sp3-Anteil, desto härter und steifer ist die DLC-Schicht.

Die Herstellung von sogenannten wasserstofffreien bzw. sauerstoff- und wasserstofffreien, amorphen diamantähnlichen Schichten wird in DE 10 2008 022 039 A1 und EP 0 724 023 A1 beschrieben.

JP 2000 128516 A offenbart ein beschichtetes Gleitelement, das eine metallische Haftschicht, eine erste, wasserstofffreie DLC-Schicht und eine zweite, wasserstoffhaltige DLC-Schicht umfasst.

Mit der hohen Härte und dem hohen E-Modul amorpher, wasserstofffreier diamantähnlicher Kohlenstoffschichten gehen allerdings auch einige technologische Probleme einher. Zum einen müssen die Oberflächen der sehr harten Schichten sehr glatt sein, damit es bei hoher Flächenpressung nicht zu Zerrüttungen auf der Oberfläche und damit zum Versagen des Schichtsystems kommt. Des Weiteren kommt es durch unterschiedliche Wärmeausdehnungskoeffizienten des Grundmaterials des Kolbenringes und dessen Beschichtung zu einem sogenannten Bimetalleffekt. Dieser wird noch durch Unterschiede im E-Modul beider Materialien verstärkt. Als Folge kommt es bei Temperaturerhöhung zu einem erhöhten Druck im Stoßbereich des Kolbenrings, der verschleißfördernd wirken kann. Ferner kann der Laufpartner (Zylinderlaufbahn) durch Riefenbildung und hohen Zwickelverschleiss beschädigt werden.

### Darstellung der Erfindung

Der Erfindung liegt die Aufgabe zu Grunde, ein Gleitelement, insbesondere einen Kolbenring für Verbrennungsmotoren, mit optimalen mechanischen sowie tribologischen Eigenschaften zu schaffen. Genauer besteht die Aufgabe darin, ein solches Gleitelement bereitzustellen, dessen Oberfläche eine möglichst geringe Reibung und/oder einen möglichst geringen Verschleiß und/oder eine hohe Brandspurbeständigkeit und/oder eine optimale Abdichtung und Ölabstreifwirkung durch hohe Geometrierobustheit sicherstellt und dadurch einen Kolbenring mit hoher Lebensdauer ermöglicht. Gegenüber bestehenden Hartstoffsystemen werden dabei eine höhere Härte und/oder eine hohe Verschleißbeständigkeit mit ausreichender Scherfestigkeit und/oder geringe Reibung und/oder Inertheit angestrebt. Ferner soll der Bimetalleffekt weitestgehend verhindert werden.

Erfindungsgemäß wird die Aufgabe durch das Gleitelement nach Anspruch 1 gelöst. Vorteilhafte Ausgestaltungen und Weiterbildungen der Erfindung können mit den in den untergeordneten Ansprüchen genannten Merkmalen erreicht werden.

Das Gleitelement, insbesondere ein Kolbenring, weist mindestens eine Lauffläche auf, auf welche eine Beschichtung aufgebracht ist, die von innen nach außen eine metallhaltige Haftschicht und eine DLC-Schicht aufweist, wobei die DLC-Schicht eine amorphe wasserstofffreie diamantähnliche Kohlenstoffschicht ist, die eine DLC-Hauptschicht aufweist, die sich von der Haftschicht bis zu einer sich anschießenden DLC-Deckschicht erstreckt und einen Kohlenstoffanteil von mehr als etwa 98,5 at%, Sauerstoff und/oder Wasserstoff und/oder Stickstoff mit einem Anteil von jeweils weniger als etwa 0,5 at% und ein sp2/sp3-Verhältnis des Kohlenstoffs zwischen etwa 1 und etwa 3 aufweist, und eine DLC-Deckschicht aufweist, die sich von der DLC-Hauptschicht zur Oberfläche des Gleitelements erstreckt und einen im Vergleich zur Hauptschicht geringeren Kohlenstoffanteil und/oder höheren Sauerstoff- und/oder höheren Wasserstoffanteil, sowie Metalle und/oder Metalloxide und ein sp2/sp3-Verhältnis des Kohlenstoffs zwischen etwa 1 und etwa 3 aufweist.

Das beschriebene Gleitelement erweist sich als vorteilhaft im Hinblick auf die Verminderung von Reibung und Verschleiß bedingt durch die hohe Härte und die guten Inerteigenschaften der DLC-Schicht. Das erfindungsgemäße sp2/sp3-Verhältnis ist besonders vorteilhaft für die Reduzierung des mittleren Ringverschleißes über den Ringumfang und den Verschleiß im Stoßbereich des Kolbenrings durch die Reduzierung des Bimetalleffektes u.a. über die Verringerung des E-Moduls. Die dadurch gesteigerte Geometrierobustheit trägt ferner zur Erhaltung optimaler Abdichtung und Ölabstreifwirkung bei.

Ferner ist insbesondere der erfindungsgemäße Bereich des sp2/sp3-Verhältnis vorteilhaft, da dieser die Einstellung einer optimalen Eigenschaftskombination aus Härte und Elastizität der DLC-Schicht zulässt. Mit Vorteil liegt das Metall, für optimale tribologische Eigenschaften, in der DLC-Deckschicht überwiegend als Metalloxid vor und wirkt dabei als Festschmierstoff. Insgesamt ergibt sich somit ein Gleitelement mit hoher Verschleißbeständigkeit und gesteigerter Lebensdauer.

Mit Vorteil weist die DLC-Schicht ein sp2/sp3-Verhältnis des Kohlenstoffs von vorzugsweise etwa 1,05 bis etwa 2 auf. Dieser bevorzugte Bereich erlaubt eine gute Anpassung der DLC-Schicht an den Grundwerkstoff des Gleitelements. Insbesondere kann das E-Modul vorteilhaft verringert und somit die Elastizität der DLC-Schicht verbessert und z.B. der Bimetalleffekt reduziert werden.

Die DLC-Deckschicht enthält in einer weiteren bevorzugten Ausführungsform Eisen und Eisenoxide, wobei diese Eisenoxide FeO und Fe₃O₄ sein können, wie mittels Röntgendiffraktometrie nachgewiesen wurden. Weiter weist die DLC-Deckschicht mit Vorteil einen Eisenanteil von etwa 30 at% oder weniger auf. Aus der Literatur ist bekannt, dass Eisenoxide als Festschmierstoffe eine Reduzierung der Reibung bewirken können. Zudem sind sie wesentlich weichere Materialien als die wasserstofffreien DLC-Beschichtungen, wodurch das Einlaufverhalten entscheidend verbessert werden kann. Ein definierter Flächenanteil dieser Metalle und Metalloxide führt zu einer Optimierung von Verschleiß, Einlaufverhalten und Reibung. Aus Messungen mittels Rasterelektronenmikroskopie im sogenannten BSE- (Back Scattered Electrons) Modus konnte der Flächenanteil des Metalls und der Metalloxide unmittelbar an der Oberfläche, gemäß einer bevorzugten Ausführungsform der Erfindung ermittelt werden. Dieser beträgt etwa 5-40 %, bevorzugt etwa 5-25 %.

Es ist insbesondere bevorzugt, dass die Metalle- und/oder Metalloxide, welche die DLC-Deckschicht aufweist, insbesondere in Rauheitstälern der DLC-Deckschicht vorhanden bzw. eingelagert sind. Weiter ist es bevorzugt, dass sich die Metalle- und/oder Metalloxide nur in der Deckschicht befinden.

Bevorzugt weist die DLC-Deckschicht weiter einen Kohlenstoffanteil von etwa 25 at% oder weniger und bevorzugt einen Sauerstoffanteil von etwa 50 at% oder weniger auf.

In vorteilhafter Weise, weist eine Oberfläche der Deckschicht unter normalen atmosphärischen Bedingungen etwa 20 at% bis zu etwa 30 at% C-O Bindungen, etwa 8 at% bis zu etwa 15 at%, bevorzugt etwa 10 at% bis zu etwa 15 at% C=O Bindungen und etwa 6 at% bis zu etwa 10 at% O-C=O Bindungen auf. Der insbesondere bei der erfindungsgemäßen Schicht erhöhte C-O-Bindungsanteil führt zu einer erhöhten Absättigung der Kohlenstoffbindung und mit Vorteil zu einer Reduzierung des Verschleißes und der Reibung.

Die DLC-Deckschicht weist eine Dicke von bis zu etwa 2 *µ*m, bevorzugt etwa 1 *µ*m auf, und die DLC-Hauptschicht weist eine Dicke von etwa 5 *µ*m bis zu etwa 40 *µ*m auf. Die bevorzugten Dicken gewährleisten in positiver Weise eine lange Standzeit und Betriebsdauer der Beschichtung und somit einen lang anhaltenden Schutz vor abrasiven und adhäsivem Verschleiß und Bauteilversagen.

Mit Vorteil erhöhen sich innerhalb der DLC-Deckschicht der Metallanteil und/oder der Sauerstoffanteil und/oder der Wasserstoffanteil zu deren Außenseite hin. Die bevorzugte Anreicherung dieser Elemente an der Außenseite führt zu vorteilhaften tribologischen Eigenschaften der Beschichtung und zur Reduzierung des mittleren Ringverschleißes über den Ringumfang und des Verschleißes im Stoßbereich des Kolbenrings.

Die DLC Schicht weist bevorzugt eine Härte von etwa 1800-3500 HV0.02 und/oder weiter bevorzugt ein E-Modul von etwa 150-320 GPa auf. Die Kombination aus hoher Härte im Vergleich zu konventionellen Hartmetallmaterialien und verminderten E-Modulen im Vergleich zu herkömmlichen, insbesondere wasserstofffreien DLC-Materialien ist besonders vorteilhaft, da so die Verschleißbeständigkeit und Geometrierobustheit erhöht und der Bimetalleffekt verringert werden kann.

Mit Vorteil weist die DLC-Schicht weiter eine mittlere Rautiefe von Rz < etwa 2 *µ*m, bevorzugt Rz < etwa 1 *µ*m und eine reduzierte Spitzenhöhe von Rpk < etwa 0,15 *µ*m, bevorzugt Rpk < etwa 0,1 *µ*m auf. Diese geringe Rauheit, die bei weicheren Oberflächenflächen mit geringerem technischen Aufwand erreicht werden kann, ist besonders vorteilhaft, da so ein Versagen des Schichtsystems durch Zerrüttung auf Grund von Unebenheiten in den harten Kohlenstoffschichten vermindert werden kann.

Die Haftschicht weist vorzugsweise eine Dicke von etwa 0,05 bis zu etwa 1,0 *µ*m auf und beinhaltet weiter bevorzugt Chrom oder Titan. Ferner ist das Grundmaterial des Gleitelements bevorzugt Gusseisen oder Stahl. Diese erfindungsgemäße Ausführungsform gewährleistet überhaupt erst eine optimale und haltbare Verbindung der verschleißmindernden DLC-Schichten mit dem Grundmaterial des Gleitelementes und trägt damit maßgeblich zu dessen Funktionsfähigkeit bei.

### Kurzbeschreibung der Figuren

Fig. 1 ist eine Darstellung des schematischen Aufbaus einer Beschichtung eines Gleitelements.
Fig. 2 ist eine rasterelektronenmikroskopische Aufnahme im BSE-(Back Scattered Electrons) Modus eines Schichtbruchs einer polierten amorphen, wasserstofffreien diamantähnlichen Kohlenstoffschicht.
Fig. 3 stellt die mittleren relativen Ringverschleißwerte über den Ringumfang der in Tabelle 1 beschriebenen und getesteten Gleitelemente dar.
Fig. 4 stellt die mittleren relativen Ringverschleißwerte im Stoßbereich der in Tabelle 1 beschriebenen und getesteten Gleitelemente dar.

### Wege zur Ausführung der Erfindung

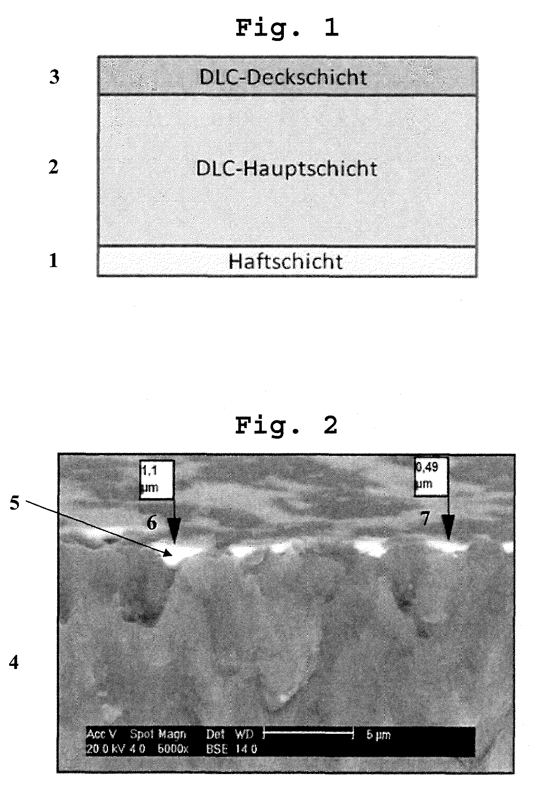

Fig. 1 stellt den erfindungsgemäßen Aufbau einer Beschichtung eines Gleitelementes dar. Direkt an den Grundwerkstoff des Gleitelementes schließt sich die Haftschicht 1 an. Auf dieser Haftschicht ist die DLC-Hauptschicht 2 aufgebracht und auf dieser, als Oberflächenschicht die DLC-Deckschicht 3.

Fig. 2 zeigt eine rasterelektronmikroskopische Seitenansicht der Beschichtung. Im materialabhängigen BSE- (Back Scattered Electrons) Kontrast erscheint das kohlenstoffhaltige Material 4 schwarz-grau. Ferner sind weiße Bereiche nahe der Schichtoberfläche zu erkennen, die eisenhaltiges Material 5 darstellen. Die Pfeile 6 und 7 geben jeweils die Dicken des eisenhaltigen Materials an ausgewählten, beispielhaften Messpunkten an.

Tabelle 1 gibt eine Übersicht über drei verschiedene Beschichtungen eines Gleitelements, insbesondere eines Kolbenringes, und listet deren Bezeichnungen, Herstellungsprozesse, Schichtdicken, mechanischen Eigenschaften und sp2/sp3-Verhältnisse auf. Das Schichtsystem "PtaC2" entspricht dabei einer bevorzugten Ausführungsform der vorliegenden Erfindung.

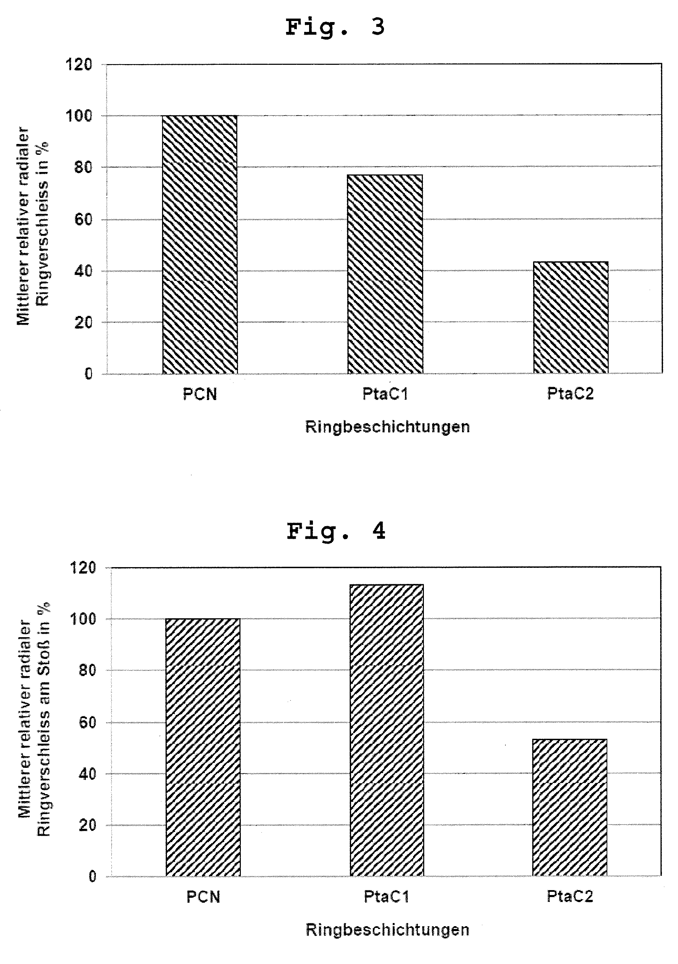

Alle Gleitelemente wurden in einem Motortest, d.h. in einem hochbelasteten Dieselmotor mit einem Verbrennungsdruck von 200 bar und einer spezifischen Leistung von 71 kW/Liter Hubraum, motorisch validiert. Fig. 3 und Fig. 4 zeigen eine Gegenüberstellung des mittleren relativen Ringverschleißes über den Ringumfang und des mittleren relativen Ringverschleißes im Stoßbereich nach 500 Stunden Laufzeit, wobei der Stand der Technik in Form der CrN-Beschichtung als Referenz (100%) verwendet wird. Die bevorzugte Ausführungsform stellt sich als besonders vorteilhaft, d.h. vergleichsweise verschleißarm dar. Dass der reduzierte sp3-Anteil dies bewirkt, erscheint im Vergleich zum Stand der Technik ungewöhnlich, da "PtaC2" eine geringere Härte und ein geringeres E-Modul als "PtaC1" aufweist.

Ferner wurde die Abdichtwirkung von, aus den Beschichtungen in Tabelle 1, gefertigten Kolbenringen mittels eines Konturschriebs an eingespannten Ringen ermittelt. Aus dem wird dann der Radialdruck über den kompletten Ringumfang bestimmt.

Im Vergleich mit "PtaC1", zeichnet sich die bevorzugte Ausführungsform "PtaC2" durch einen im Ringstoß nahezu drucklosen Bereich mit geringem Einzug aus, und ist lichtspaltdicht. Das weist auf eine gute Geömetrierobustheit und Abdichtwirkung auch bei höheren Temperaturen hin.

Weiter kann die notwendige Oberflächenbearbeitung der mit "PtaC" bezeichneten Schichten deren Mikrostruktur und oberflächliche Zusammensetzung verändern. So wurde mittels SIMS (Sekundär Ionen Massenspektroskopie) gemessen, dass es bei den Schichten "PtaC1" und "PtaC2" nach der Bearbeitung/Glättung zu einer Erhöhung des Sauerstoffanteils von < etwa 0,5 at% in einer Tiefe von etwa 500 nm bis zum Grundmaterial auf bis zu etwa 47 at% im oberflächennahen Bereich gekommen ist. Ebenfalls stieg der Eisenanteil von < etwa 1 % auf bis zu etwa 23 % und der Kohlenstoffanteil sank von ca. 99 at% in der Tiefe der DLC-Schicht auf bis zu etwa 30 at% im oberflächennahen Bereich.

**Tabelle 1**

| Bezeichnung | Herstellungsprozess | Schichtdicke [*µ*m] | E-Modul [GPa] | Härte [HV0.02] | sp2/sp3-Verhältnis |
|---|---|---|---|---|---|
| PCN | PVD | 32 | 230-270 | 1180-1370 | - |
| "PtaC1" | PVD | 22 | 370-410 | 3300-4500 | 0,8-1 |
| "PtaC2" | PVD | 23 | 185-210 | 2470-2940 | 1,05-2 |

Tabelle 2 gibt, basierend auf REM- (Rasterelektronenmikroskopie) Untersuchungen, den Fe-Flächenanteil für die Beschichtungen "PtaC1" und "PtaC2" an. Des Weiteren gibt Tabelle 2, basierend auf XPS- (X-ray Photoelectron Spectroscopy) Messungen und daher für einen ca. 10 nm dicken Bereich der Oberfläche d.h. der Deckschicht 3, die Kohlenstoff-Sauerstoff-Bindungsverhältnisse an.

Verglichen mit "PtaC1", zeichnet sich die, einer bevorzugten Ausführungsform der Erfindung entsprechende, Beschichtung "PtaC2", durch einen vergleichsweise großen Fe-Flächenanteil, sowie einen höheren Anteil von C-O Einfachbindungen aus. Es ist zu erwarten, dass der nicht mit Sauerstoff gebundene Kohlenstoff in einer normalen Atmosphäre eine Bindung mit Wasserstoff eingeht, die eine geringere Bildungsenthalpie besitzt als eine C-O Verbindung und daher die "PtaC1" gegenüber der erfindungsgemäßen "PtaC2" einen geringeren Verschleißwiderstand sowie eine höhere Reibung aufweisen wird. Dieser Bindungstyp ist jedoch nicht mittels XPS nachweisbar.

**Tabelle 2**

| Schichtbezeichnung | Fe-Flächenanteil [%] (REM-Me s sungen) | C O Bindungsanteile [at %] (XPS-Messungen) | | |
|---|---|---|---|---|
| | | C-O | C=O | O-C=O |
| "PtaC1" | 13,8-27,3 | 11,7 | 10,3 | 6,0 |
| "PtaC2" | 11,7-36,5 | 24,7 | 11,3 | 8,0 |

Das erfindungsgemäße Gleitelement kann mittels PVD-Verfahren erzeugt werden, indem zum Beispiel Chrom als Haftschicht und Kohlenstoff verdampft, ionisiert und über elektromagnetische Felder auf einem Grundmaterial des Gleitelements abgeschieden werden. Die weitere Bearbeitung des Gleitelements erfolgt durch einen anschließenden Prozess, bei dem es in Verbindung mit einem thermochemischen Prozess, zum Beispiel einer temperaturinduzierten Oxidation, zu einem Materialübertrag von einem metallischen Bearbeitungsmaterial kommt. Im Ergebnis lagern sich entsprechende Metall- und/oder Metalloxide in Rauheitstälern der DLC-Deckschicht ein, wie deutlich an den weißen Bereichen in Fig. 2 zu erkennen ist.

## Patentansprüche

1. Gleitelement, insbesondere Kolbenring, mit mindestens einer Lauffläche, die eine Beschichtung aufweist, welche von innen nach außen eine metallhaltige Haftschicht und eine DLC-Schicht aufweist, wobei die DLC-Schicht eine amorphe wasserstofffreie diamantähnliche Kohlenstoffschicht ist, die eine DLC-Hauptschicht aufweist, die sich von der Haftschicht bis zu einer sich anschießenden DLC-Deckschicht erstreckt und einen Kohlenstoffanteil von mehr als etwa 98,5 at%, Sauerstoff und/oder Wasserstoff und/oder Stickstoff mit einem Anteil von jeweils weniger als etwa 0,5 at% und ein sp2/sp3-Verhältnis des Kohlenstoffs zwischen etwa 1 und etwa 3 aufweist, und eine DLC-Deckschicht aufweist, die sich von der DLC-Hauptschicht zur Oberfläche des Gleitelements erstreckt und einen im Vergleich zur Hauptschicht geringeren Kohlenstoffanteil und/oder höheren Sauerstoff- und/oder höheren Wasserstoffanteil, sowie Metalle und/oder Metalloxide und ein sp2/sp3-Verhältnis des Kohlenstoffs zwischen etwa 1 und etwa 3 aufweist.

2. Gleitelement gemäß Anspruch 1, wobei die DLC-Schicht ein sp2/sp3-Verhältnis des Kohlenstoffs von vorzugsweise etwa 1,05 bis zu etwa 2 aufweist.

3. Gleitelement gemäß einem der vorangegangenen Ansprüche 1-2, wobei die DLC-Deckschicht Eisen und/oder Eisenoxide aufweist.

4. Gleitelement gemäß Anspruch 3, wobei die Eisenoxide FeO und/oder Fe₃O₄ sind.

5. Gleitelement gemäß einem der vorangegangenen Ansprüche 1-4, wobei die DLC-Deckschicht einen Eisenanteil von etwa 30 at% oder weniger aufweist.

6. Gleitelement gemäß einem der vorangegangenen Ansprüche 1-5, wobei die DLC-Deckschicht einen Kohlenstoffanteil von etwa 25 at% oder mehr aufweist.

7. Gleitelement gemäß einem der vorangegangenen Ansprüche 1-6, wobei die DLC-Deckschicht einen Sauerstoffanteil von etwa 50 at% oder weniger aufweist.

8. Gleitelement gemäß einem der vorangegangenen Ansprüche 1-7, wobei eine Oberfläche der DLC-Deckschicht folgende C O Bindungsanteile aufweist:
• C-O etwa 20 at% bis zu etwa 30 at%,
• C=O etwa 8 at% bis zu etwa 15 at%, bevorzugt etwa 10 at% bis zu etwa 15 at%,
• O-C=O etwa 6 at% bis zu etwa 10 at%.

9. Gleitelement gemäß einem der vorangegangen Ansprüche 1-8, wobei die, an der Oberfläche der Beschichtung befindlichen Metalle und/oder Metalloxide einen Flächenanteil von etwa 5-40 %, bevorzugt von etwa 5-25 % aufweisen.

10. Gleitelement gemäß einem der vorangegangenen Ansprüche 1-9, wobei die DLC-Deckschicht eine Dicke von bis zu etwa 2 *µ*m, bevorzugt etwa 1 *µ*m aufweist.

11. Gleitelement gemäß einem der vorangegangenen Ansprüche 1-10, wobei die DLC-Hauptschicht eine Dicke von etwa 5 *µ*m bis zu etwa 40 *µ*m aufweist.

12. Gleitelement gemäß einem der vorangegangenen Ansprüche 1-11, wobei sich innerhalb der DLC-Deckschicht der Metallanteil und/oder der Sauerstoffanteil und/oder der Wasserstoffanteil zu deren Außenseite hin erhöhen/erhöht.

13. Gleitelement gemäß einem der vorangegangenen Ansprüche 1-12, wobei die DLC-Schicht eine Härte von etwa 1800-3500 HV0.02 aufweist.

14. Gleitelement gemäß einem der vorangegangenen Ansprüche 1-13, wobei die DLC-Schicht ein E-Modul von etwa 150-320 GPa aufweist.

15. Gleitelement gemäß einem der vorangegangenen Ansprüche 1-14, wobei die DLC Schicht eine mittlere Rautiefe von Rz < etwa 2 *µ*m, bevorzugt Rz < etwa 1 *µ*m und eine reduzierte Spitzenhöhe Rpk < etwa 0,15 *µ*m, bevorzugt Rpk < etwa 0,1 *µ*m aufweist.

16. Gleitelement gemäß einem der vorangegangenen Ansprüche 1-15, wobei die Haftschicht eine Dicke von etwa 0,05 *µ*m bis zu etwa 1,0 *µ*m aufweist.

17. Gleitelement gemäß einem der vorangegangenen Ansprüche 1-16, wobei die Haftschicht Chrom oder Titan aufweist.

18. Gleitelement gemäß einem der vorangegangenen Ansprüche 1-17, wobei ein Grundmaterial des Gleitelementes Gusseisen oder Stahl ist.

## Claims

1. Sliding element, in particular piston ring, having at least one running surface which has a coating which from the inside to the outside has a metal-containing adhesive layer and a DLC layer, wherein the DLC layer is an amorphous hydrogen-free diamond-like carbon layer which has a DLC main layer which extends from the adhesive layer as far as an adjoining DLC cover layer and has a carbon content of more than about 98.5 at%, oxygen and/or hydrogen and/or nitrogen having a content of in each case less than about 0.5 at% and an sp2/sp3 ratio of carbon between about 1 and about 3, and has a DLC cover layer which extends from the DLC main layer to the surface of the sliding element and has a lower carbon content and/or higher oxygen content and/or higher hydrogen content compared to the main layer, as well as metals and/or metal oxides and an sp2/sp3 ratio of carbon between about 1 and about 3.

2. Sliding element according to claim 1, wherein the DLC layer has an sp2/sp3 ratio of carbon of preferably about 1.05 up to about 2.

3. Sliding element according to one of the preceding claims 1-2, wherein the DLC cover layer has iron and/or iron oxides.

4. Sliding element according to claim 3, wherein the iron oxides are FeO and/or Fe₃O₄.

5. Sliding element according to one of the preceding claims 1-4, wherein the DLC cover layer has an iron content of about 30 at% or less.

6. Sliding element according to one of the preceding claims 1-5, wherein the DLC cover layer has a carbon content of about 25 at% or more.

7. Sliding element according to one of the preceding claims 1-6, wherein the DLC cover layer has an oxygen content of about 50 at% or less.

8. Sliding element according to one of the preceding claims 1-7, wherein a surface of the DLC cover layer has the following C O bonding components:
• C-O about 20 at% up to about 30 at%,
• C=O about 8 at% up to about 15 at%, preferably about 10 at% up to about 15 at%,
• O-C=O about 6 at% up to about 10 at%.

9. Sliding element according to one of the preceding claims 1-8, wherein the metals and/or metal oxides located on the surface of the coating have a surface component of about 5-40 %, preferably of about 5-25 %.

10. Sliding element according to one of the preceding claims 1-9, wherein the DLC cover layer has a thickness of up to about 2 µm, preferably about 1 µm.

11. Sliding element according to one of the preceding claims 1-10, wherein the DLC main layer has a thickness of about 5 µm up to about 40 µm.

12. Sliding element according to one of the preceding claims 1-11, wherein within the DLC cover layer, the metal content and/or the oxygen content and/or the hydrogen content is/are increased towards the outer side thereof.

13. Sliding element according to one of the preceding claims 1-12, wherein the DLC layer has a hardness of about 1,800-3,500 HV0.02.

14. Sliding element according to one of the preceding claims 1-13, wherein the DLC layer has a modulus of elasticity of about 150-320 GPa.

15. Sliding element according to one of the preceding claims 1-14, wherein the DLC layer has an average roughness depth of Rz < about 2 µm, preferably Rz < about 1 µm and a reduced peak height Rpk < about 0.15 µm, preferably Rpk < about 0.1 µm.

16. Sliding element according to one of the preceding claims 1-15, wherein the adhesive layer has a thickness of about 0.05 µm up to about 1.0 µm.

17. Sliding element according to one of the preceding claims 1-16, wherein the adhesive layer contains chromium or titanium.

18. Sliding element according to one of the preceding claims 1-17, wherein a base material of the sliding element is cast iron or steel.

## Revendications

1. Elément de glissement, en particulier segment de piston, comprenant au moins une surface mobile, qui présente un revêtement, laquelle présente, de l'intérieur vers l'extérieur, une couche adhésive contenant du métal et une couche DLC, dans lequel la couche DLC est une couche de carbone amorphe identique au diamant sans hydrogène, laquelle présente une couche DLC principale, qui s'étend de la couche adhésive à une couche de recouvrement DLC s'y raccordant et qui présente une fraction carbone supérieure à environ 98,5 % en atomes, de l'oxygène et/ou de l'hydrogène et/ou de l'azote avec une fraction respectivement inférieure à 0,5 % en atomes et un rapport sp2/sp3 du carbone compris entre environ 1 et environ 3, et une couche de recouvrement DLC, qui s'étend de la couche DLC principale à la surface de l'élément de glissement et qui présente une fraction en carbone inférieure et/ou une fraction d'oxygène plus importante et/ou une fraction d'hydrogène plus importante en comparaison de la couche principale, ainsi que des métaux et/ou des oxydes métalliques et un rapport sp2/sp3 du carbone compris entre environ 1 et environ 3.

2. Elément de glissement selon la revendication 1, dans lequel la couche DLC présente un rapport sp2/sp3 du carbone de préférence allant d'environ 1,05 à environ 2.

3. Elément de glissement selon l'une quelconque des revendications précédentes 1 à 2, dans lequel la couche DLC de recouvrement présente du fer et/ou des oxydes de fer.

4. Elément de glissement selon la revendication 3, dans lequel les oxydes de fer sont du FeO et/ou du Fe₃O₄.

5. Elément de glissement selon l'une quelconque des revendications 1 à 4, dans lequel la couche DLC de recouvrement présente une fraction de fer d'environ 30 % en atomes ou moins.

6. Elément de glissement selon l'une quelconque des revendications précédentes 1 à 5, dans lequel la couche DLC de recouvrement présente une fraction de carbone d'environ 25 % en atomes ou plus.

7. Elément de glissement selon l'une quelconque des revendications 1 à 6, dans lequel la couche DLC de recouvrement présente une fraction d'oxygène d'environ 50 % en atomes ou moins.

8. Elément de glissement selon l'une quelconque des revendications précédentes 1 à 7, dans lequel une surface de la couche DLC de recouvrement présente des fractions de liaison de C et de O qui suivent :
- C-O environ 20 % en atomes à environ 30 % en atomes,
- C=O environ 8 % en atomes à environ 15 % en atomes, de manière préférée environ 10 % en atomes à environ 15 % en atomes,
- O-C=O environ 6 % en atomes à environ 10 % en atomes.

9. Elément de glissement selon l'une quelconque des revendications précédentes 1 à 8, dans lequel les métaux et/ou les oxydes métalliques se trouvant au niveau de la surface du revêtement présentent une fraction de surface d'environ 5 à 40 %, de manière préférée d'environ 5 à 25 %.

10. Elément de glissement selon l'une quelconque des revendications 1 à 9, dans lequel la couche DLC de recouvrement présente une épaisseur allant jusqu'à environ 2 *µ*m, de manière préférée environ 1 *µ*m.

11. Elément de glissement selon l'une quelconque des revendications précédentes 1 à 10, dans lequel la couche DLC principale présente une épaisseur allant d'environ 5 *µ*m à environ 40 *µ*m.

12. Elément de glissement selon l'une quelconque des revendications précédentes 1 à 11, dans lequel la fraction de métal et/ou la fraction d'oxygène et/ou la fraction d'hydrogène augmente(nt) à l'intérieur de la couche DLC de recouvrement jusqu'au côté extérieur de cette dernière.

13. Elément de glissement selon l'une quelconque des revendications précédentes 1 à 12, dans lequel la couche DLC présente une dureté d'environ 1800 à 3500 HVO.02.

14. Elément de glissement selon l'une quelconque des revendications précédentes 1 à 13, dans lequel la couche DLC présente un e-module d'environ 150 à 320 GPa.

15. Elément de glissement selon l'une quelconque des revendications précédentes 1 à 14, dans lequel la couche DLC présente une profondeur de rugosité moyenne Rz < environ 2 *µ*m, de manière préférée une Rz < environ 1 *µ*m et une hauteur de pic réduite Rpk < environ 0,15 *µ*m, de manière préférée une Rpk < environ 0,1 *µ*m.

16. Elément de glissement selon l'une quelconque des revendications précédentes 1 à 15, dans lequel la couche adhésive présente une épaisseur allant d'environ de 0,05 *µ*m à environ 1,0 *µ*m.

17. Elément de glissement selon l'une quelconque des revendications précédentes 1 à 16, dans lequel la couche adhésive présente du chrome ou du titane.

18. Elément de glissement selon l'une quelconque des revendications précédentes 1 à 17, dans lequel un matériau de base de l'élément de glissement est de la fonte ou de l'acier.
